# EUROPEAN PATENT APPLICATION

(11) **EP 4 530 026 A1**
(43) Date of publication of application: **02.04.2025**
(21) Application number: 23201061.1
(22) Date of filing: 29.09.2023
(51) Int. Cl.: B25J 9/16

(54) **PLANNING HINT GENERATION FOR COLLISION FREE MOTIONS**

(71) Applicant: Siemens Aktiengesellschaft, 80333 München (DE)
(72) Inventor: MCDANIEL, Richard Gary, Hightstown, NJ, 08520 (US); NEUBAUER, Werner, 81739 München (DE); SCHMITT, Philipp Sebastian, 80797 München (DE)
(74) Representative: Horn Kleimann Waitzhofer Schmid-Dreyer Patent- und Rechtsanwälte PartG mbB

(57) **Abstract**

A system can define planning hints that indicate where a robot can be moved or positioned. Collision-free paths for the robot can be generated using the planning hints.

## Description

### BACKGROUND

Autonomous operations, such as robotic grasping and placing, in unknown or dynamic environments present various technical challenges. When developing an automation application, robots often need to move within dynamic environments that can include numerous machines or objects. In such environments, preprogramming the robot motions can result in collisions or other undesirable robot poses or paths. Furthermore, it is recognized herein that current computer-aided design (CAD) tools for motion planning often result in inefficient or undesirable robot motions.

### BRIEF SUMMARY

Embodiments of the invention address and overcome one or more of the described-herein shortcomings or technical problems by providing methods, systems, and apparatuses for enhancing user interface tools for various autonomous systems. For example, a system can define planning hints that denote or indicate poses and locations within a work environment where robots can move.

In an example aspect, an automation computing system can generate a model of an automation system includes a work environment and a robot configured to move within the work environment. The system can position a first planning hint within the work environment that is used for robot motion planning. The planning hint can define a first pose of the robot that can be used in moving the robot from an initial pose to a target pose. The system can also display a graphical representation of the robot positioned in the first pose. Using the planning hint, the system can generate a path for the robot to move from the initial pose to the target pose without colliding with any objects. In an example, the path includes the robot moving into the first pose between the initial pose and the target pose. In another example, the system can position a plurality of planning hints within the work environment. Each planning hint can define a respective pose and location of the robot within the work environment. Using the plurality of planning hints, the system can generate a plurality of paths for the robot to move from the initial pose to the target pose. In an example, at least one path of the plurality of paths defines a collision-free path in which the robot avoids collisions with any objects. In some cases, the at least one path includes at least one of the poses and locations defined by at least one of the planning hints. In another example, the at least one path includes no more than two of the poses and locations defined by no more than two of the planning hints.

### BRIEF DESCRIPTION OF THE SEVERAL VIEWS OF THE DRAWINGS

The foregoing and other aspects of the present invention are best understood from the following detailed description when read in connection with the accompanying drawings. For the purpose of illustrating the invention, there is shown in the drawings embodiments that are presently preferred, it being understood, however, that the invention is not limited to the specific instrumentalities disclosed. Included in the drawings are the following Figures:
FIG. 1 shows an example user interface (UI) that defines two planning hints indicating locations within a working environment for moving a robot, in accordance with an example embodiment.
FIG. 2A shows another example UI that defines a new pose element or six degree of freedom, in accordance with an example embodiment.
FIG. 2B illustrates a property editor of the UI for setting properties of the new pose element, in accordance with an example embodiment.
FIG. 3A shows the UI with a graphical representation of the robot moved to the location and pose corresponding to the pose element.
FIG. 3B shows the property editor of FIG. 2B with the pose element being assigned to a planning hint, in accordance with an example embodiment.
FIG. 4 shows the UI with a graphical representation of a six degree of freedom pose element.
FIG. 5A is a graph that illustrates example movement strategies for moving a robot from an initial pose to a target pose.
FIG. 5B is a graph that that illustrates example movement strategies for moving a robot from an initial pose to a target pose, via a planning hint position, in accordance with an example embodiment.
FIG. 6 is a graph that illustrates example movement strategies for moving a robot from an initial pose to a target pose, via multiple planning hint positions, in accordance with an example embodiment.
FIG. 7 illustrates a computing environment within which embodiments of the disclosure may be implemented.

### DETAILED DESCRIPTION

Various interfaces are described herein for 3D editing, in accordance with various embodiments. Such interfaces can be used as the front end for robot motion planning services in a robotic library for programmable logic controllers (PLCs).

As an initial matter, a goal of a collision free motion planning service is to produce a path that moves a robot from its current position to another target location without running into another object along the way. Even if the target pose for the robot is known, there can be various paths that reach the target pose. To determine the best path, in some cases, a search accounts for robot joint limits and changes in the overall configuration, possibly passing through singular positions where the joint configuration is not continuous. Thus, it is recognized herein that the motion of a given robot is often not obvious while it also often preferred that the motion is simple and efficient. But various potential paths might be blocked by objects that need to be avoided. It is further recognized herein that technical challenges need to be addressed in order to efficiently search for and produce collision-free efficient paths with minimal user interaction.

By way of background, it is recognized herein that robot programming is typically explicit. For example, a programmer might use code to command a robot to move to various locations. The positions of the robot can be specified using numeric values and data structures representing joint positions and paths. Some robots are programmed explicitly using teach points that represent recorded robotic poses that are stored in a robot application. Such teach points can be referenced by issued commands. The poses may be generated by using the manual interface of the robot to put it in a particular pose, or it may be "demonstrated" by putting the robot's motors into a resistive state, grabbing the robot manually, and physically moving it into the desired pose. The teach point may also be demonstrated virtually by using a digital representation of the robot and putting that representation into the desired pose.

For a robot to operate autonomously, it can infer important attributes of its environment and act accordingly. In some cases, robots operate within a range from completely programmed and command driven to completely autonomous and sensor driven. In more autonomous scenarios, the path that the robot follows is often not predetermined. When the robot moves in new ways or along new paths, it is important that the robot does not collide with unintended objects, such as the work surface, fixtures, other robots, and the like. In order to avoid collisions, in some cases, the application should ascertain the other physical objects that may interfere with the robot's movement, and then calculate a path that avoids the obstacles. In accordance with various embodiments described herein, paths are calculated that avoid obstacles. In some examples, to find obstacles, the system uses a world model in which the expected constituents of a given work cell are prepared and described in advance in sufficient detail. Additionally, or alternatively, the system can use sensors, such as a 3D camera, that can survey an area around the robot and update a dynamic world model as the application progresses.

To calculate paths for a given pose of a robot, in various examples, it is determined whether various positions would result in a collision with an unintended obstacle. For example, the system can search a given workspace of all robotic poses to find a path that is collision free. There are various algorithms for finding collisions between three dimensional (3D) shapes. Typically, the robot and obstacle shapes are simplified to polyhedrons with fewer facets, concave surfaces, or simplified geometries to make shape intersection easier and more efficient to calculate.

It is recognized herein, however, that various technical challenges exist in searching the robot's pose space. For example, the number of dimensions in the robot's pose can make simple search strategies impractical. Furthermore, it is undesirable to create paths that, although feasible, are unnecessarily complicated and/or produce undesirable movements. Current approaches tend to be based on random values such as the Probabilistic RoadMap (PRM) and the Rapidly exploring Random Tree (RRT) algorithms. Both algorithms create random robot poses to create a search space of possible paths. Without filtering the results, it is recognized herein that both approaches tend to create peculiar robot motions that often move away from the target as much as toward. Even with filtering, it is further recognized herein that the motions still tend to contain undesirable artifacts such as extra motions on unnecessary joints.

It is recognized herein that a goal of various industrial processes is to move materials by a robot along paths are not unnecessarily complicated. It is further recognized herein, however, that automatically finding an uncomplicated path for a robot can present various technical challenges. For example, in some cases, robots process elements that occur in hundreds of locations with varying paths and destinations that are only known at processing time. Conversely, by way of example, if a robot services only one path, even if the path is complicated, the path might be programmed once and then robot can repeat the path. Many industrial tasks, though, are unknown until it is time to execute an operation, such as picking randomly distributed objects from a bin or loading a cargo hold, for example.

Producing a path where there are obstacles can present a challenge in that, although there may be many possible simple paths, finding a strategy that works for any possible situation can be difficult. For example, in a pick and place scenario, a strategy to move the robot's end effector in an arc-like path travelling upward to an open space above the materials being picked to travel laterally might work well. But in another example scenario where objects are placed vertically instead of horizontally, the same arc-like motion might fail. In such scenarios, a general path finding solution such as RRT can treat the topology of the scene like a puzzle, and it is recognized herein that the resulting solutions tend to be overly complicated.

Thus, embodiments described herein can, in some cases, define a balance between general path finding solutions and user directed commands. For example, an application developer can provide one or more planning hints to indicate key positions in which the robot may move to in a given workspace. Such key positions can define space that is generally open to further movement and away from obstacles that might block the robot. In various examples, a planning hint does not define a waypoint, in that the robot might not be commanded to move to the position or location corresponding to the planning hint at any time. In some examples, however, the robot may automatically select to move to the planning hint location when other options are calculated to be unavailable. Furthermore, path generation algorithms may use a particular planning hint, or a given planning hint might be ignored by path generation operations, for instance depending on the current robot position and destination. In an example, the developer might provide a set of planning hints in a constellation of key positions around the application's work area. In particular, for example, hints might be placed in bottleneck areas of the space where there are more obstacles, or areas that require the robot to shift into a particular configuration to move through the area.

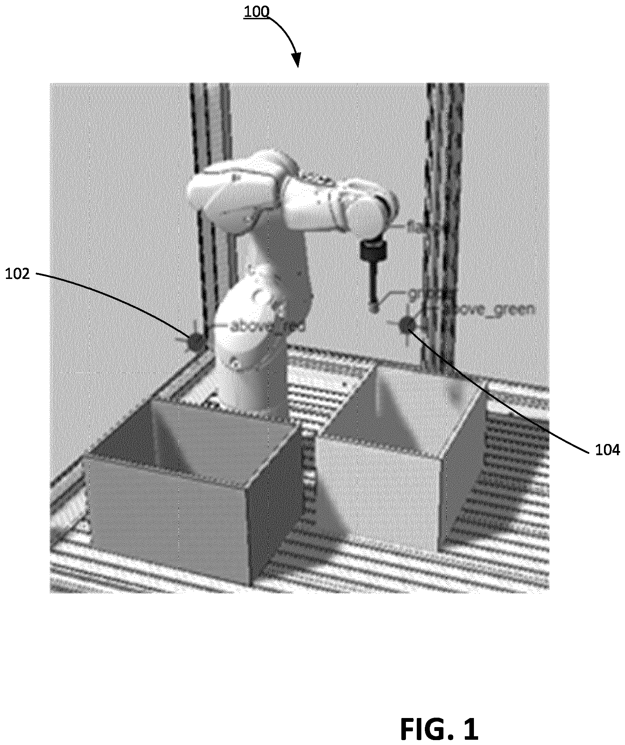

Referring now to FIG. 1, a computing automation system can define various user interfaces (UIs), for instance a UI 100 that allows users (e.g., application developers) to generate planning hint objects, for instance a first planning hint 102 and a second planning hint 104. In an example, the planning hint objects are produced as elements of a three-dimensional (3D) modeling editor. A 3D editor can be used to assemble a model of the work cell or environment of a given robot application. The model can define the knowledge base for the location of collision surfaces when computing collision-free motions. The 3D editor can also act as a testing rig for verifying that robot motions will act as expected when moving between various locations.

In various examples, the application developer (user) can create a model of a given work cell by adding components such as, for example, robots, fixtures, work materials, attachments to the robots (e.g., wiring harnesses, grippers, cameras, etc.), and the like. The user may also introduce semantic components to the model (e.g., semantic markers) that represent various indications, such as robot positions, how to grip materials, locations where materials are placed, and the like. Semantic markers can denote various behaviors in various automation systems or applications. For example, the computing automation system can define a low-code, programming environment that can be used to specify an automation application by using 3D graphical analogs of components that comprise the automation application, and of work materials that the automation application manages or modifies. In particular, for example, the 3D graphical analogs of components can include a six degree of freedom (DOF) pose component (or pose element). The pose element can represent the joint configuration of a particular robot reaching out to a given position.

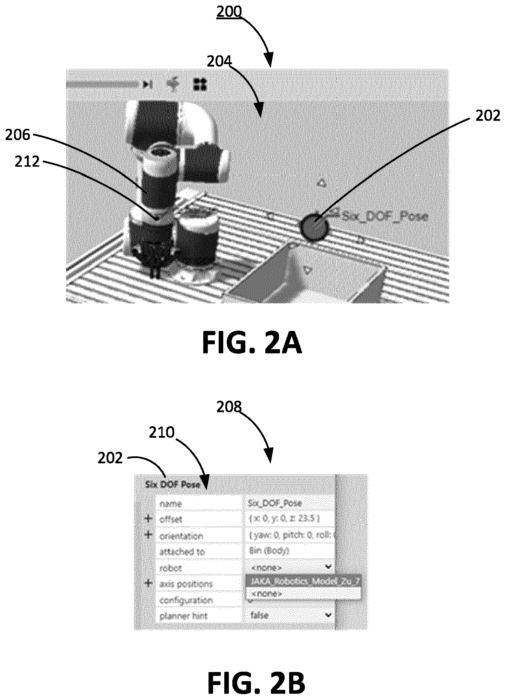

Referring also to FIG. 2A, an example UI 200 can define a new pose element or six DOF component 202. For example, the UI 100 can define a palette that renders marker objects or elements, for instance the pose element 202. In an example, the user can drag an instance of element 202 from the palette to a position in 3D model space 204, so as to add the new pose element 202 to the model. The new pose element 202 may begin in an unassigned state in which it is not yet attached to a robot 206. In various examples, the new pose element 202 may define a graphical appearance (e.g., color, shape, etc.) that indicates that the pose element 202 is unassigned. Referring also to FIG. 2B, the user may assign the pose element 202 to a robot, for instance the robot 206, using a property editor 208 defined by the UI. When the pose element 202 is assigned to the robot 206, the pose element 202 may graphically represent how the robot 206 would reach the position of the element 202. If the robot 206 cannot reach that position, the graphical representation may indicate that situation. By way of example, and without limitation, the graphical representation may define a different color, icon, or other user interface technique to indicate that the robot 206 cannot reach the position defined by the pose element 202.

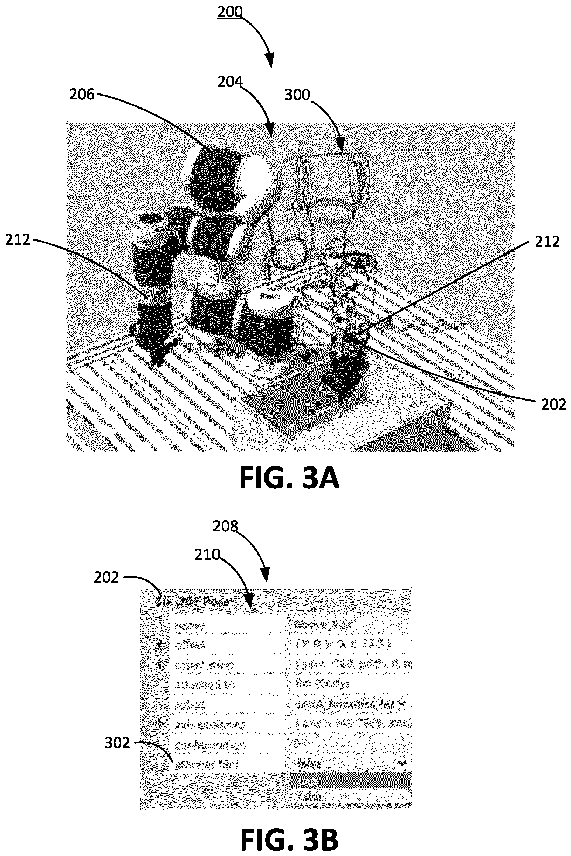

Referring in particular to FIG. 2B, the pose element 202 may be associated with various other parameters 210 that can be included in the property editor 208. In various examples, the user can input values associated with the parameters 210 so as to adjust the robot's pose (e.g., angular or linear joint values for the robot's axes), a configuration for which direction joint values should be calculated, or a tool center point (TCP) indication. The TCP indication can define the location on the robot 206 (or components attached to the robot 206) that is used as the point for which the pose is calculated. By way of example, referring to FIG. 3A, the robot 206 can define a flange 212 having a flange TCP. When the TCP indication corresponds to the flange 212, the system can render a graphical representation 300 places the flange TCP at the location defined by the pose element 202. In various examples, the original joint positions of the robot object are not changed. Furthermore, in some cases, the robot's position can be changed to match the location of the pose element 202. Thus, in various examples, the user can create multiple pose elements for a given robot and quickly and easily change between the multiple pose elements.

The six DOF pose component 202 can be used for different purposes. In an example, the six DOF pose component 202 can define a waypoint in traditional robot programming. In another example, the six DOF pose component 202 can illustrate or record the axis positions of a real connected robot. In accordance with various embodiments described herein, the six DOF components or pose elements, in particular the pose element 202, define planning hints. For example, referring also to FIG. 3B, the user or application developer can assign the pose element 202 as a planning hint by setting a planner hint parameter or property 302 of the parameters 210 to true.

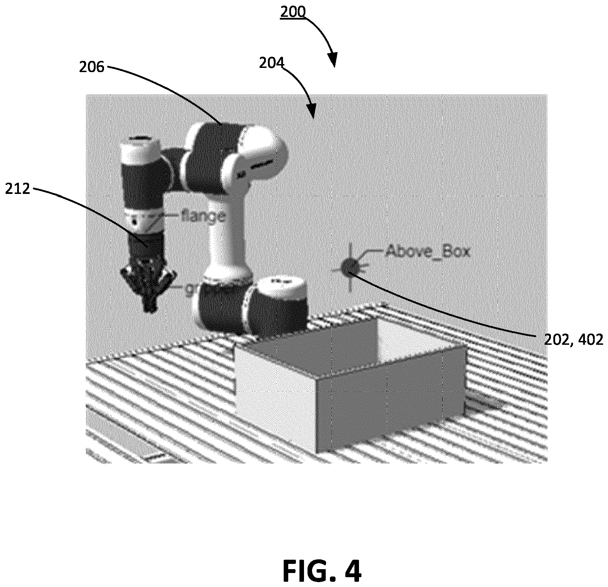

Referring now to FIG. 4, the pose element 202 is set to a planning hint 402 via the property editor 210. The pose element 202 that is set to the planning hint 402 can define an alternative graphical appearance as compared to a pose element that is not a planning hint. By way of example, and without limitation, the planning hint 402 might be illustrated with a colored circular mark at the center of crosshairs defined by the pose element 202. It will be understood that planning hints might be alternatively rendered on the UI so that they are visually distinguishable from other pose elements that are not set as planning hints, and all such alternative renderings are contemplated as being within the scope of this disclosure. Furthermore, although one pose element 202 is illustrated as a planning hint 402, it will be understood that a user can assign multiple pose elements to be used as planning hints that are spaced from each other. The one or more planning hints can provide indications to the system as to where the robot 206 can be moved to reach a given destination. Thus, in various examples, the planning hints do not define entire paths, but rather one or more locations that are desirable or capable of being included in a path generated by the system.

In an example, after the planning hints, for instance the planning hint 402, are set, the system can use the planning hints to generate collision-free paths. In some examples, a command language is used to create directives to move the robot 206 in different ways to produce a path. In some cases, the commands can represent a set of primitive movements such as incrementing the value of an axis joint in two-degree steps or translating the position of the robot's TCP along an X-axis or first direction. The commands may incorporate variables that encode key information about the needed movement, such as the current robot state, the target robot state, various reference frames (e.g., the global frame), and other variables that access application data such as, for example and without limitation, the location of obstacles, other robots, and user provided markers (e.g., planning hints).

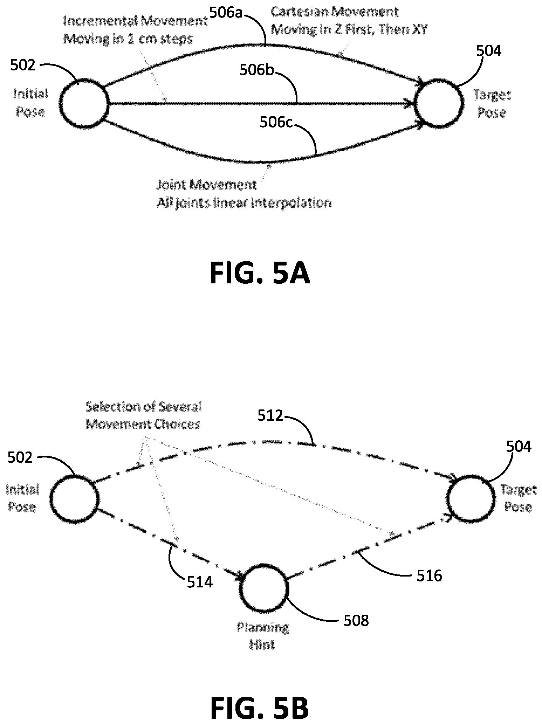

Referring now to FIG. 5A, the computing automation system can generate various paths from an initial position or pose 502 defined by the robot 206 to an intended target destination or pose 504 of the robot 206. The system can use the command primitives to determine one or more paths for moving the robot from the initial pose 502 to the target pose 504. The system can determine paths based on various movement strategies, for instance a first movement strategy 506a, a second movement strategy 506b, and a third strategy 506c. Although movement strategies are illustrated in FIG. 5A, it will be understood that the system can select alternative or additional movement strategies as desired, and all such movement strategies are contemplated as being within the scope of this disclosure. By way of example, the first movement strategy 506a can include the robot 206 moving its TCP in Cartesian coordinates. The second movement strategy 506b can include the robot 206 moving in one fell swoop in small increments between the initial pose 502 and the target pose 504. The third movement strategy 506c can include the robot 206 moving in its joint space. The movement strategies 506a-c can specify respective movements between any two robot poses, for instance between the initial pose 502 and the target pose 504. Referring to FIG. 5A, the lines at 506a-c between the initial pose 502 and the target pose 504 can represent respective strategies for searching for a collision free path, thus are not representative of the physical movement the robot 206 may actually take. The actual movement may be curved or straight depending on the commands the strategy takes. A valid path is defined when the robot can move to the target position 504 without colliding into other objects. One, more than one, or none of the strategies 506a-c might result in a collusion free and valid path. When the strategies 506a-c result in multiple paths that are valid, the system can select one of the valid paths based on various criteria. For example, the first path discovered might be selected or the path with the least joint movement might be selected. FIG. 5A represents example paths that are generated using strategies 506a-c that do not include any planning hints.

Referring to FIG. 5B, the user can provide a planning hint 508 that can define an intermediate point along a path between the initial pose 502 and the target pose 504. Thus, for the pose-to-pose transition between the initial pose 502 and the final pose 504, the system can generate one or more paths or movement choices that include or exclude the position of the planning hint 508. For each movement path, for instance a first path 512, a second path 514, and a third path 516, multiple strategies may be employed such as the Cartesian, incremental movement, and joint movement strategies 506a-c. Based on the planning hints, the system can generate search commands that incorporate the planning hint positions as part of the search path. If there is only a single planning hint pose, such as the planning hint 508 of FIG. 5B, then the system might generate a path based on the first path 512 using strategies 506a-c in which the robot travels from the initial pose 502 directly to the target pose 504. Additionally, the system might generate another path that includes the second and third paths 514 and 516 in which the robot travels from the initial pose 502 to the pose defined by the planning hint 508 using any of the strategies 506a-c, and then to from the planning hint pose to the target pose 504 also using strategies 506a-c. Thus, multiple strategies can be implemented for searching for a collision-free path, and the strategies can be merged in FIG. 5B to form respective single dotted lines. A valid strategy is one that results in collision free motion for the portion of the path being traveled. In various examples, any one valid strategy in the multi-strategy line can make the entire line in FIG. 5B valid. To be a completely valid path, there is a valid strategy in a continuous line from the initial pose 502 to the target pose 504. Thus, a valid path can be defined by the selected strategy for 512 that moves directly from the initial pose 502 to the target pose 504, or by the strategies independently selected for 514 and 516 in which the robot moves from the initial pose 502, via the planning hint pose 508, to the target pose 504. In some cases, the search strategy to find a complete valid path might include performing a depth-first search starting with the paths with the smallest number of intermediate poses. Each strategy in each path segment can be tested and if any are valid, the system can begin checking paths in the next set of connected strategies.

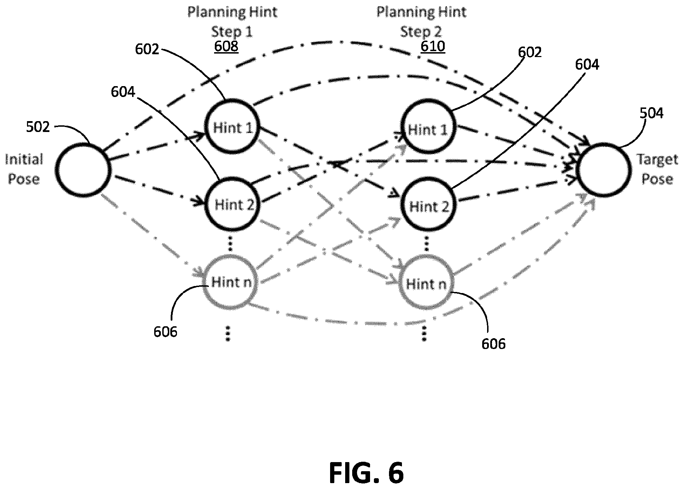

Referring now to FIG. 6, when there are multiple planning hints, such as a first planning hint 602, a second planning hint 604, and a third planning hint 606, the system can limit the number of search paths by restricting the number of hints that may be used as intermediate steps. In an example, the number of steps can be restricted to two, for instance a first step 608 and a second step 610, though it will be understood that the system can be restricted to an alternative number of steps, for instance a user can request additional steps to be included, and all such numbers of steps are contemplated as being within the scope of this disclosure. In some cases, using more than two planning hints as steps can result in the hint positions performing as waypoints in that the system might search for different sequences of the possible pose positions defined by the planning hints.

Still referring to FIG. 6, the system can generate a search pattern when there are two or more planning hints (e.g., planning hints 602, 604, and 606) using a maximum two step path (e.g., steps 608 and 610). For example, the system can generate paths that define direct movement between the initial position and the target position 504, and paths that define direct movement from the first planning hint step 608 to the target position 504, among other paths. In various examples, the system omits strategies for traveling from a given planning hint to itself because the robot would already be at that location of the given planning hint. Similarly, in systems defining more than two steps, paths that backtrack to previously visited hints may be excluded for the same reason. Thus, still referring to FIG. 6, the system might find valid path from the initial pose 502 to the target pose 504 with no hints, one intermediate hint (e.g., planning hint 602, 604, or 606), or two intermediate hints. In some examples, the system can prioritize paths with the least number of steps or the least overall robot motion. The system may also perform further refinements to the path such as simplifying the motion by removing sharp turns or zigzag movements. In various examples, after path selection and refinement, the final motion path is checked to verify that it is collision-free. Alternatively, for example, if the entire graph of FIG. 6 is searched and there are no valid paths from the initial pose 502 to the target pose 504, the system can render an indication to the user that no path is found. For error handling, in some cases, the system can indicate the search paths where valid steps, so as to indicate how far the system was able to move the robot before no collision-free path was found.

Thus, as described herein, planning hints or positions can be provided that do not define waypoints. For example, the actual path that a robot uses might use the planning position in its path, or it may rely on other positions that are not defined by planning hints. The system described herein can incorporate the planning hint positions non-deterministically and, in some cases, only applies the planning hints if they are needed. For example, a robot might choose to use an intermediate pose corresponding to a planning hint when the direct path between two locations is blocked. The system may also optimize movement by selecting between multiple intermediate points and choosing the path that maximizes some criteria such as, for example, minimal joint movement.

As further described herein, an automation computing system can generate a model of an automation system includes a work environment and a robot configured to move within the work environment. The system can position a first planning hint within the work environment that is used for robot motion planning. The planning hint can define a first pose of the robot that can be used in moving the robot from an initial pose to a target pose. The system can also display a graphical representation of the robot positioned in the first pose. Using the planning hint, the system can generate a path for the robot to move from the initial pose to the target pose without colliding with any objects. In an example, the path includes the robot moving into the first pose between the initial pose and the target pose. In another example, the system can position a plurality of planning hints within the work environment. Each planning hint can define a respective pose and location of the robot within the work environment. Using the plurality of planning hints, the system can generate a plurality of paths for the robot to move from the initial pose to the target pose. In an example, at least one path of the plurality of paths defines a collision-free path in which the robot avoids collisions with any objects. In some cases, the at least one path includes at least one of the poses and locations defined by at least one of the planning hints. In another example, the at least one path includes no more than two of the poses and locations defined by no more than two of the planning hints.

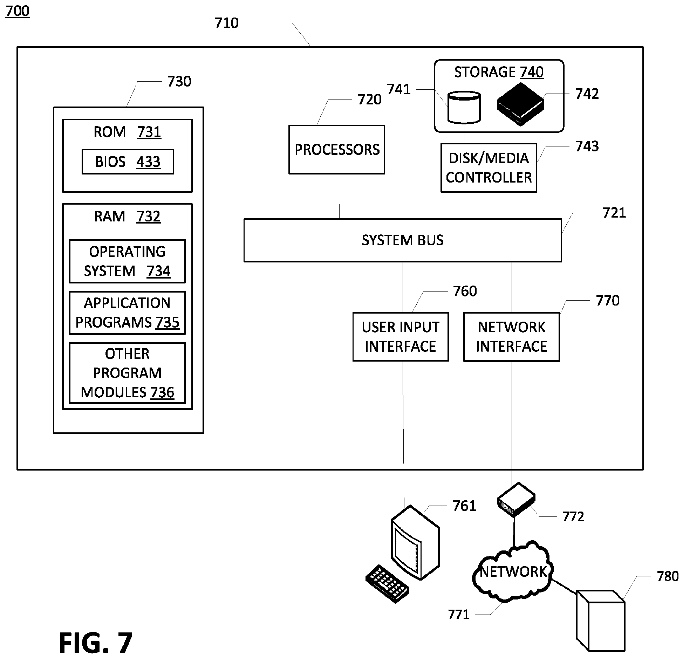

FIG. 7 illustrates an example of a computing environment that can include the simulation system within which embodiments of the present disclosure may be implemented. A computing environment 700 includes a computer system 710 that may include a communication mechanism such as a system bus 721 or other communication mechanism for communicating information within the computer system 710. The computer system 710 further includes one or more processors 720 coupled with the system bus 721 for processing the information.

The processors 720 may include one or more central processing units (CPUs), graphical processing units (GPUs), or any other processor known in the art. More generally, a processor as described herein is a device for executing machine-readable instructions stored on a computer readable medium, for performing tasks and may comprise any one or combination of, hardware and firmware. A processor may also comprise memory storing machine-readable instructions executable for performing tasks. A processor acts upon information by manipulating, analyzing, modifying, converting or transmitting information for use by an executable procedure or an information device, and/or by routing the information to an output device. A processor may use or comprise the capabilities of a computer, controller or microprocessor, for example, and be conditioned using executable instructions to perform special purpose functions not performed by a general purpose computer. A processor may include any type of suitable processing unit including, but not limited to, a central processing unit, a microprocessor, a Reduced Instruction Set Computer (RISC) microprocessor, a Complex Instruction Set Computer (CISC) microprocessor, a microcontroller, an Application Specific Integrated Circuit (ASIC), a Field-Programmable Gate Array (FPGA), a System-on-a-Chip (SoC), a digital signal processor (DSP), and so forth. Further, the processor(s) 720 may have any suitable micro architecture design that includes any number of constituent components such as, for example, registers, multiplexers, arithmetic logic units, cache controllers for controlling read/write operations to cache memory, branch predictors, or the like. The micro architecture design of the processor may be capable of supporting any of a variety of instruction sets. A processor may be coupled (electrically and/or as comprising executable components) with any other processor enabling interaction and/or communication there-between. A user interface processor or generator is a known element comprising electronic circuitry or software or a combination of both for generating display images or portions thereof. A user interface comprises one or more display images enabling user interaction with a processor or other device.

The system bus 721 may include at least one of a system bus, a memory bus, an address bus, or a message bus, and may permit exchange of information (e.g., data (including computer-executable code), signaling, etc.) between various components of the computer system 710. The system bus 721 may include, without limitation, a memory bus or a memory controller, a peripheral bus, an accelerated graphics port, and so forth. The system bus 721 may be associated with any suitable bus architecture including, without limitation, an Industry Standard Architecture (ISA), a Micro Channel Architecture (MCA), an Enhanced ISA (EISA), a Video Electronics Standards Association (VESA) architecture, an Accelerated Graphics Port (AGP) architecture, a Peripheral Component Interconnects (PCI) architecture, a PCI-Express architecture, a Personal Computer Memory Card International Association (PCMCIA) architecture, a Universal Serial Bus (USB) architecture, and so forth.

Continuing with reference to FIG. 7, the computer system 710 may also include a system memory 730 coupled to the system bus 721 for storing information and instructions to be executed by processors 720. The system memory 730 may include computer readable storage media in the form of volatile and/or nonvolatile memory, such as read only memory (ROM) 731 and/or random access memory (RAM) 732. The RAM 732 may include other dynamic storage device(s) (e.g., dynamic RAM, static RAM, and synchronous DRAM). The ROM 731 may include other static storage device(s) (e.g., programmable ROM, erasable PROM, and electrically erasable PROM). In addition, the system memory 730 may be used for storing temporary variables or other intermediate information during the execution of instructions by the processors 720. A basic input/output system 733 (BIOS) containing the basic routines that help to transfer information between elements within computer system 710, such as during start-up, may be stored in the ROM 731. RAM 732 may contain data and/or program modules that are immediately accessible to and/or presently being operated on by the processors 720. System memory 730 may additionally include, for example, operating system 734, application programs 735, and other program modules 736. Application programs 735 may also include a user portal for development of the application program, allowing input parameters to be entered and modified as necessary.

The operating system 734 may be loaded into the memory 730 and may provide an interface between other application software executing on the computer system 710 and hardware resources of the computer system 710. More specifically, the operating system 734 may include a set of computer-executable instructions for managing hardware resources of the computer system 710 and for providing common services to other application programs (e.g., managing memory allocation among various application programs). In certain example embodiments, the operating system 734 may control execution of one or more of the program modules depicted as being stored in the data storage 740. The operating system 734 may include any operating system now known or which may be developed in the future including, but not limited to, any server operating system, any mainframe operating system, or any other proprietary or non-proprietary operating system.

The computer system 710 may also include a disk/media controller 743 coupled to the system bus 721 to control one or more storage devices for storing information and instructions, such as a magnetic hard disk 741 and/or a removable media drive 742 (e.g., floppy disk drive, compact disc drive, tape drive, flash drive, and/or solid state drive). Storage devices 740 may be added to the computer system 710 using an appropriate device interface (e.g., a small computer system interface (SCSI), integrated device electronics (IDE), Universal Serial Bus (USB), or FireWire). Storage devices 741, 742 may be external to the computer system 710.

The computer system 710 may perform a portion or all of the processing steps of embodiments of the invention in response to the processors 720 executing one or more sequences of one or more instructions contained in a memory, such as the system memory 730. Such instructions may be read into the system memory 730 from another computer readable medium of storage 740, such as the magnetic hard disk 741 or the removable media drive 742. The magnetic hard disk 741 (or solid state drive) and/or removable media drive 742 may contain one or more data stores and data files used by embodiments of the present disclosure. The data store 740 may include, but are not limited to, databases (e.g., relational, object-oriented, etc.), file systems, flat files, distributed data stores in which data is stored on more than one node of a computer network, peer-to-peer network data stores, or the like. The data stores may store various types of data such as, for example, skill data, sensor data, or any other data generated in accordance with the embodiments of the disclosure. Data store contents and data files may be encrypted to improve security. The processors 720 may also be employed in a multi-processing arrangement to execute the one or more sequences of instructions contained in system memory 730. In alternative embodiments, hard-wired circuitry may be used in place of or in combination with software instructions. Thus, embodiments are not limited to any specific combination of hardware circuitry and software.

As stated above, the computer system 710 may include at least one computer readable medium or memory for holding instructions programmed according to embodiments of the invention and for containing data structures, tables, records, or other data described herein. The term "computer readable medium" as used herein refers to any medium that participates in providing instructions to the processors 720 for execution. A computer readable medium may take many forms including, but not limited to, non-transitory, non-volatile media, volatile media, and transmission media. Non-limiting examples of non-volatile media include optical disks, solid state drives, magnetic disks, and magneto-optical disks, such as magnetic hard disk 741 or removable media drive 742. Non-limiting examples of volatile media include dynamic memory, such as system memory 730. Non-limiting examples of transmission media include coaxial cables, copper wire, and fiber optics, including the wires that make up the system bus 721. Transmission media may also take the form of acoustic or light waves, such as those generated during radio wave and infrared data communications.

Computer readable medium instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to embodiments of the disclosure. It will be understood that each block of the flowchart illustrations and/or block diagrams, and combinations of blocks in the flowchart illustrations and/or block diagrams, may be implemented by computer readable medium instructions.

The computing environment 700 may further include the computer system 710 operating in a networked environment using logical connections to one or more remote computers, such as remote computing device 780. The network interface 770 may enable communication, for example, with other remote devices 780 or systems and/or the storage devices 741, 742 via the network 771. Remote computing device 780 may be a personal computer (laptop or desktop), a mobile device, a server, a router, a network PC, a peer device or other common network node, and typically includes many or all of the elements described above relative to computer system 710. When used in a networking environment, computer system 710 may include modem 772 for establishing communications over a network 771, such as the Internet. Modem 772 may be connected to system bus 721 via user network interface 770, or via another appropriate mechanism.

Network 771 may be any network or system generally known in the art, including the Internet, an intranet, a local area network (LAN), a wide area network (WAN), a metropolitan area network (MAN), a direct connection or series of connections, a cellular telephone network, or any other network or medium capable of facilitating communication between computer system 710 and other computers (e.g., remote computing device 780). The network 771 may be wired, wireless or a combination thereof. Wired connections may be implemented using Ethernet, Universal Serial Bus (USB), RJ-6, or any other wired connection generally known in the art. Wireless connections may be implemented using Wi-Fi, WiMAX, and Bluetooth, infrared, cellular networks, satellite or any other wireless connection methodology generally known in the art. Additionally, several networks may work alone or in communication with each other to facilitate communication in the network 771.

It should be appreciated that the program modules, applications, computer-executable instructions, code, or the like depicted in FIG. 7 as being stored in the system memory 730 are merely illustrative and not exhaustive and that processing described as being supported by any particular module may alternatively be distributed across multiple modules or performed by a different module. In addition, various program module(s), script(s), plug-in(s), Application Programming Interface(s) (API(s)), or any other suitable computer-executable code hosted locally on the computer system 710, the remote device 780, and/or hosted on other computing device(s) accessible via one or more of the network(s) 771, may be provided to support functionality provided by the program modules, applications, or computer-executable code depicted in FIG. 7 and/or additional or alternate functionality. Further, functionality may be modularized differently such that processing described as being supported collectively by the collection of program modules depicted in FIG. 7 may be performed by a fewer or greater number of modules, or functionality described as being supported by any particular module may be supported, at least in part, by another module. In addition, program modules that support the functionality described herein may form part of one or more applications executable across any number of systems or devices in accordance with any suitable computing model such as, for example, a client-server model, a peer-to-peer model, and so forth. In addition, any of the functionality described as being supported by any of the program modules depicted in FIG. 7 may be implemented, at least partially, in hardware and/or firmware across any number of devices.

It should further be appreciated that the computer system 710 may include alternate and/or additional hardware, software, or firmware components beyond those described or depicted without departing from the scope of the disclosure. More particularly, it should be appreciated that software, firmware, or hardware components depicted as forming part of the computer system 710 are merely illustrative and that some components may not be present or additional components may be provided in various embodiments. While various illustrative program modules have been depicted and described as software modules stored in system memory 730, it should be appreciated that functionality described as being supported by the program modules may be enabled by any combination of hardware, software, and/or firmware. It should further be appreciated that each of the above-mentioned modules may, in various embodiments, represent a logical partitioning of supported functionality. This logical partitioning is depicted for ease of explanation of the functionality and may not be representative of the structure of software, hardware, and/or firmware for implementing the functionality. Accordingly, it should be appreciated that functionality described as being provided by a particular module may, in various embodiments, be provided at least in part by one or more other modules. Further, one or more depicted modules may not be present in certain embodiments, while in other embodiments, additional modules not depicted may be present and may support at least a portion of the described functionality and/or additional functionality. Moreover, while certain modules may be depicted and described as sub-modules of another module, in certain embodiments, such modules may be provided as independent modules or as sub-modules of other modules.

Although specific embodiments of the disclosure have been described, one of ordinary skill in the art will recognize that numerous other modifications and alternative embodiments are within the scope of the disclosure. For example, any of the functionality and/or processing capabilities described with respect to a particular device or component may be performed by any other device or component. Further, while various illustrative implementations and architectures have been described in accordance with embodiments of the disclosure, one of ordinary skill in the art will appreciate that numerous other modifications to the illustrative implementations and architectures described herein are also within the scope of this disclosure. In addition, it should be appreciated that any operation, element, component, data, or the like described herein as being based on another operation, element, component, data, or the like can be additionally based on one or more other operations, elements, components, data, or the like. Accordingly, the phrase "based on," or variants thereof, should be interpreted as "based at least in part on."

Although embodiments have been described in language specific to structural features and/or methodological acts, it is to be understood that the disclosure is not necessarily limited to the specific features or acts described. Rather, the specific features and acts are disclosed as illustrative forms of implementing the embodiments. Conditional language, such as, among others, "can," "could," "might," or "may," unless specifically stated otherwise, or otherwise understood within the context as used, is generally intended to convey that certain embodiments could include, while other embodiments do not include, certain features, elements, and/or steps. Thus, such conditional language is not generally intended to imply that features, elements, and/or steps are in any way required for one or more embodiments or that one or more embodiments necessarily include logic for deciding, with or without user input or prompting, whether these features, elements, and/or steps are included or are to be performed in any particular embodiment.

## Claims

1. A computer-implemented method, the method comprising:
generating a model of an automation system comprising a work environment and a robot configured to move within the work environment;
positioning a first planning hint within the work environment, the planning hint defining a first pose of the robot that can be used in moving the robot from an initial pose to a target pose; and
displaying a graphical representation of the robot positioned in the first pose.

2. The method as recited in claim 1, the method further comprising: using the planning hint, generating a path for the robot to move from the initial pose to the target pose without colliding with any objects.

3. The method as recited in claim 2, wherein the path includes the robot moving into the first pose between the initial pose and the target pose.

4. The method as recited in claim 1, positioning a plurality of planning hints within the work environment, each planning hint defining a respective pose and location of the robot within the work environment.

5. The method as recited in claim 4, the method further comprising:
using the plurality of planning hints, generating a plurality of paths for the robot to move from the initial pose to the target pose.

6. The method as recited in claim 5, wherein at least one path of the plurality of paths defines a collision-free path in which the robot avoids collisions with any objects.

7. The method as recited in claim 6, wherein the at least one path includes at least one of the poses and locations defined by at least one of the planning hints.

8. The method as recited in claim 7, wherein the at least one path includes no more than two of the poses and locations defined by no more than two of the planning hints.

9. A computing automation system, the computing automation system comprising:
a processor; and
a memory storing instructions that, when executed by the processor, cause the computing system to:
generate a model of an automation system comprising a work environment and a robot configured to move within the work environment;
position a first planning hint within the work environment, the planning hint defining a first pose of the robot that can be used in moving the robot from an initial pose to a target pose; and
display a graphical representation of the robot positioned in the first pose.

10. The system as recited in claim 9, the memory further storing instructions that, when executed by the processor, further cause the computing system to:
use the planning hint to generate a path for the robot to move from the initial pose to the target pose without colliding with any objects.

11. The system as recited in claim 10, wherein the path includes the robot moving into the first pose between the initial pose and the target pose.

12. The system as recited in claim 9, the memory further storing instructions that, when executed by the processor, further cause the computing system to:
position a plurality of planning hints within the work environment, each planning hint defining a respective pose and location of the robot within the work environment.

13. The system as recited in claim 12, the memory further storing instructions that, when executed by the processor, further cause the computing system to:
use the plurality of planning hints to generate a plurality of paths for the robot to move from the initial pose to the target pose.

14. The system as recited in claim 13, wherein at least one path of the plurality of paths defines a collision-free path in which the robot avoids collisions with any objects.

15. The system as recited in claim 14, wherein the at least one path includes at least one of the poses and locations defined by at least one of the planning hints.
